# EUROPEAN PATENT APPLICATION

(11) **EP 4 748 575 A1**
(43) Date of publication of application: **27.05.2026**
(21) Application number: 25218495.7
(22) Date of filing: 25.11.2025
(51) Int. Cl.: B41J 2/14, B41J 2/16

(54) **LIQUID EJECTING HEAD, LIQUID EJECTING APPARATUS, AND METHOD OF MANUFACTURING LIQUID EJECTING HEAD**

(30) Priority: 25.11.2024 JP 2024204491
(71) Applicant: Seiko Epson Corporation, Tokyo 160-8801 (JP)
(72) Inventor: YANO, Yoshiki, Suwa-shi, 392-8502 (JP); OHASHI, Koji, Suwa-shi, 392-8502 (JP); NAGANO, Daisuke, Suwa-shi, 392-8502 (JP); ITO, Nobuaki, Suwa-shi, 392-8502 (JP); OKADA, Shu, Suwa-shi, 392-8502 (JP)
(74) Representative: Lewis Silkin LLP

(57) **Abstract**

A liquid ejecting head includes a pressure chamber substrate having a plurality of pressure chambers arranged in a first direction, a diaphragm disposed on the pressure chamber substrate, a first electrode disposed on the diaphragm, a piezoelectric layer disposed on the first electrode, a second electrode disposed on the piezoelectric layer, and a seed layer located between the piezoelectric layer and the diaphragm for controlling orientation of the piezoelectric layer. The piezoelectric layer includes a first region not overlapping the first electrode in the first direction, and a second region overlapping the first electrode in the first direction. The seed layer includes a first seed layer disposed not in the first region but in the second region, and a second seed layer provided on the first seed layer and disposed over both the first region and the second region.

## Description

The present application is based on, and claims priority from JP Application Serial Number 2024-204491, filed November 25, 2024, the disclosure of which is hereby incorporated by reference herein in its entirety.

### BACKGROUND

### 1. Technical Field

The present disclosure relates to a liquid ejecting head, a liquid ejecting apparatus, and a method of manufacturing a liquid ejecting head.

### 2. Related Art

In a liquid ejecting head in which a diaphragm, a first electrode, a piezoelectric layer, and a second electrode are stacked in this order on a pressure chamber substrate having a plurality of pressure chambers, a seed layer for controlling the orientation of the piezoelectric layer may be provided between the piezoelectric layer and the diaphragm. For example, JP-A-2017-37932 describes that a single-layer seed layer is uniformly formed on a patterned first electrode, and then a piezoelectric layer is formed on the seed layer.

In the configuration of JP-A-2017-37932, a material contained in the layer immediately below the first electrode is intensively precipitated at an end portion of the first electrode by heat treatment during the formation of the seed layer. When such local segregation of the material occurs, the material becomes an oxide, and the piezoelectric layer is detached at an end portion of the first electrode. As a result, there is a concern that a crack may occur.

### SUMMARY

To solve the problem described above, according to a preferred aspect of the present disclosure, there is provided a liquid ejecting head including: a pressure chamber substrate having a plurality of pressure chambers arranged in a first direction; a diaphragm disposed on the pressure chamber substrate; a first electrode disposed on the diaphragm; a piezoelectric layer disposed on the first electrode; a second electrode disposed on the piezoelectric layer; and a seed layer located between the piezoelectric layer and the diaphragm for controlling orientation of the piezoelectric layer. The piezoelectric layer includes a first region not overlapping the first electrode in the first direction, and a second region overlapping the first electrode in the first direction. The seed layer includes a first seed layer disposed not in the first region but in the second region, and a second seed layer provided on the first seed layer and disposed over both the first region and the second region.

According to a preferred aspect of the present disclosure, there is provided a liquid ejecting apparatus including: the liquid ejecting head according to the aspect described above; and a control section that controls an ejecting operation from the liquid ejecting head.

According to a preferred aspect of the present disclosure, a method of manufacturing a liquid ejecting head that includes a pressure chamber substrate having a plurality of pressure chambers arranged in a first direction and a diaphragm disposed on the pressure chamber substrate, the method includes the steps, in order: applying a layer to be formed of a material of a first electrode onto the diaphragm; applying a layer to be formed of a material of a first seed layer onto the layer to be formed of the material of the first electrode; subjecting the layer formed of the material of the first seed layer to heat treatment; patterning the layer formed of the material of the first electrode and the layer formed of the material of the first seed layer; applying a layer to be formed of a material of a second seed layer onto the diaphragm and onto the layer formed of the material of the first seed layer; subjecting the layer formed of the material of the second seed layer to heat treatment; and applying a piezoelectric body on the layer formed of the material of the second seed layer.

### BRIEF DESCRIPTION OF THE DRAWINGS

FIG. 1 is a schematic view illustrating a configuration example of a liquid ejecting apparatus according to embodiments.
FIG. 2 is an exploded perspective view of a liquid ejecting head according to a first embodiment.
FIG. 3 is a sectional view taken along line III-III in FIG. 2.
FIG. 4 is a plan view of a portion of the liquid ejecting head illustrated in FIG. 2.
FIG. 5 is a sectional view taken along line V-V in FIG. 4.
FIG. 6 is an enlarged view of portion VI in FIG. 5.
FIG. 7 is an explanatory view of a method of manufacturing a liquid ejecting head according to the embodiments.
FIG. 8 is an explanatory view of the method of manufacturing the liquid ejecting head according to the embodiments.
FIG. 9 is an explanatory view of a method of manufacturing a liquid ejecting head according to Comparative Example 1.
FIG. 10 is an explanatory view of a method of manufacturing a liquid ejecting head according to Comparative Example 2.

### DESCRIPTION OF EMBODIMENTS

Hereinafter, preferred embodiments according to the present disclosure will be described with reference to the accompanying drawings. In the drawings, dimensions and scale of each section are appropriately different from actual ones, and some sections are schematically illustrated for easy understanding. In addition, the scope of the present disclosure is not limited to these forms unless it is stated in the following description that the present disclosure is particularly limited.

For convenience, an X axis, a Y axis, and a Z axis intersecting with each other will be appropriately used in the following description. Hereinafter, one direction along the X axis will be referred to as an X1 direction, and a direction opposite to the X1 direction will be referred to as an X2 direction. Similarly, directions opposite to each other along the Y axis are a Y1 direction and a Y2 direction. The Y1 direction or the Y2 direction is an example of a "first direction". Further, directions opposite to each other along the Z axis are a Z1 direction and a Z2 direction. The Z1 direction is an example of a "second direction". Hereinafter, viewing in the Z1 direction or the Z2 direction may be referred to as "plan view".

Here, typically, the Z axis is a vertical axis, and the Z2 direction corresponds to a downward direction in the vertical direction. However, the Z axis may not be a vertical axis. The X axis, the Y axis, and the Z axis are typically orthogonal to each other, but are not limited thereto, and need only intersect each other at an angle within a range of, for example, 80° or more and 100° or less.

### 1: First Embodiment

### 1-1: Overall Configuration of Liquid Ejecting Apparatus

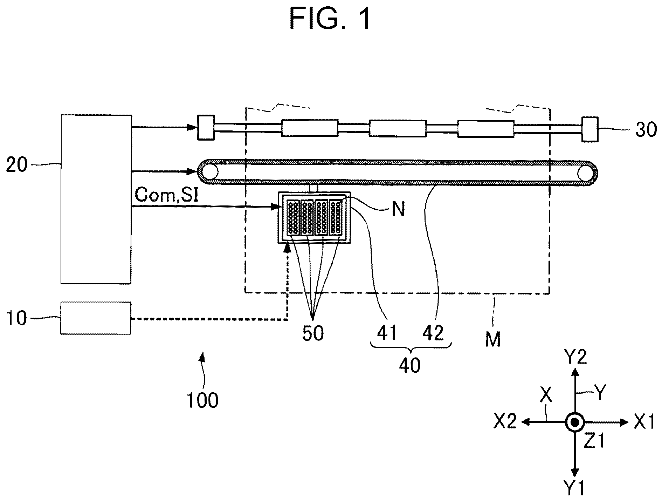

FIG. 1 is a schematic view illustrating a configuration example of a liquid ejecting apparatus 100 according to the embodiments. The liquid ejecting apparatus 100 is an ink jet printing apparatus that ejects ink, which is an example of "liquid", as a liquid droplet toward a recording medium M. The recording medium M is, for example, printing paper. The recording medium M is not limited to printing paper, and may be, for example, a printing target of any material such as a resin film or fabric.

As illustrated in FIG. 1, the liquid ejecting apparatus 100 includes a liquid container 10, a control module 20, a transport mechanism 30, a moving mechanism 40, and a plurality of liquid ejecting heads 50. The control module 20 is an example of a "control section".

The liquid container 10 stores inks. Specific aspects of the liquid container 10 include, for example, a cartridge that can be attached to and detached from the liquid ejecting apparatus 100, a bag-shaped ink pack formed of a flexible film, and an ink tank that can be refilled with ink. The type of ink stored in the liquid container 10 is appropriately selected.

The control module 20 controls an operation of each element of the liquid ejecting apparatus 100. The control module 20 includes, for example, a processing circuit such as a central processing unit (CPU) or a field programmable gate array (FPGA) and a storage circuit such as a semiconductor memory. Here, the control module 20 outputs a drive signal Com for driving the liquid ejecting heads 50 and a control signal SI for controlling the driving of the liquid ejecting heads 50. The control module 20 controls an ejecting operation from the liquid ejecting heads 50 by the drive signal Com and the control signal SI.

The transport mechanism 30 transports the recording medium M along the Y axis under the control of the control module 20.

The moving mechanism 40 reciprocates the liquid ejecting heads 50 along the X axis under the control of the control module 20. The moving mechanism 40 includes a substantially box-shaped transport body 41 called a carriage for accommodating the liquid ejecting heads 50, and an endless transport belt 42 to which the transport body 41 is fixed. The transport body 41 may be provided with the liquid container 10 described above in addition to the liquid ejecting heads 50.

Each of the plurality of liquid ejecting heads 50 ejects the ink supplied from the liquid container 10 onto the recording medium M from each of a plurality of nozzles N under the control of the control module 20. This ejection is performed in parallel with the transport of the recording medium M by the transport mechanism 30 and the reciprocating movement of the liquid ejecting heads 50 by the moving mechanism 40, and thus an image is formed with the ink on a surface of the recording medium M.

In the example illustrated in FIG. 1, the number of the liquid ejecting heads 50 is four. The number of liquid ejecting heads 50 is not limited to the example illustrated in FIG. 1, and may be any number, and may be one, or may be a plural number of three or less, or five or more. Further, the arrangement of the plurality of liquid ejecting heads 50 is not limited to the example illustrated in FIG. 1, and is appropriately selected.

### 1-2: Liquid Ejecting Head

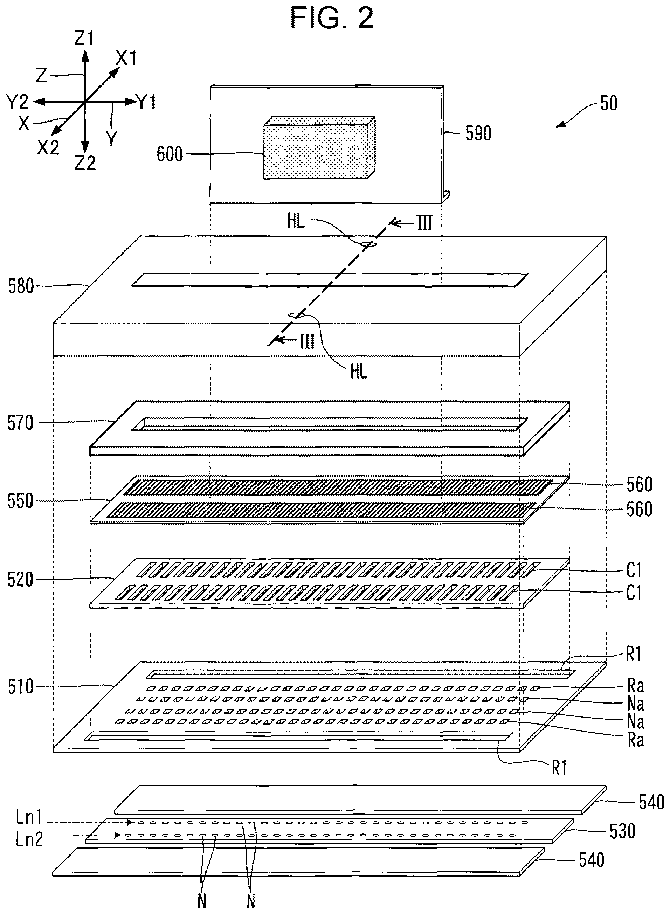

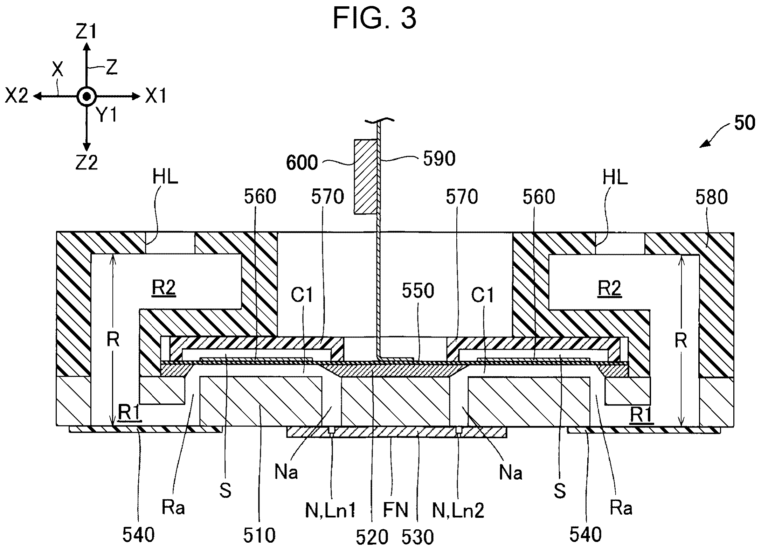

FIG. 2 is an exploded perspective view of the liquid ejecting head 50 according to the first embodiment. FIG. 3 is a sectional view taken along line III-III in FIG. 2. Hereinafter, an example of the configuration of the liquid ejecting head 50 will be described.

As illustrated in FIGS. 2 and 3, the liquid ejecting head 50 has a plurality of nozzles N arranged in a direction along the Y axis.

The plurality of nozzles N included in the liquid ejecting head 50 are divided into a first nozzle row Ln1 and a second nozzle row Ln2 arranged at an interval from each other in the direction along the X axis. Each of the first nozzle row Ln1 and the second nozzle row Ln2 is a set of the plurality of nozzles N linearly arranged in the direction along the Y axis.

The liquid ejecting head 50 has a substantially symmetrical configuration in the direction along the X axis. However, positions of the plurality of nozzles N of the first nozzle row Ln1 and the plurality of nozzles N of the second nozzle row Ln2 in the direction along the Y axis may coincide with each other or may be different from each other. FIGS. 2 and 3 exemplify a configuration in which the positions of the plurality of nozzles N of the first nozzle row Ln1 and the plurality of nozzles N of the second nozzle row Ln2 in the direction along the Y axis coincide with each other.

As illustrated in FIGS. 2 and 3, the liquid ejecting head 50 includes a communication substrate 510, a pressure chamber substrate 520, a nozzle plate 530, a vibration absorber 540, a diaphragm 550, a plurality of piezoelectric elements 560, a protective substrate 570, a case 580, and a wiring substrate 590.

The communication substrate 510 and the pressure chamber substrate 520 are stacked in this order in the Z1 direction and form a flow path for supplying the ink to the plurality of nozzles N. The diaphragm 550, the plurality of piezoelectric elements 560, the protective substrate 570, the case 580, the wiring substrate 590, and the drive circuit 600 are installed in a region located in the Z1 direction with respect to a stacked body formed by the communication substrate 510 and the pressure chamber substrate 520. On the other hand, the nozzle plate 530 and the vibration absorber 540 are installed in a region located in the Z2 direction with respect to the stacked body. Each element of the liquid ejecting head 50 is schematically a plate-shaped member elongated in the Y direction and is bonded to each other by, for example, an adhesive. Hereinafter, each element of the liquid ejecting head 50 will be described in order.

The nozzle plate 530 is a plate-shaped member in which the plurality of nozzles N of each of the first nozzle row Ln1 and the second nozzle row Ln2 are provided. Each of the plurality of nozzles N is a through hole through which the ink passes. Here, a surface of the nozzle plate 530 facing the Z2 direction is a nozzle surface FN. The nozzle plate 530 is manufactured, for example, through processing of a single-crystal silicon substrate by a semiconductor manufacturing technique using a processing technique such as dry etching or wet etching. However, other known methods and materials may be appropriately used to manufacture the nozzle plate 530. In addition, the cross-sectional shape of each of the nozzles N is typically a circular shape, but is not limited thereto, and may be a non-circular shape such as a polygonal shape or an elliptical shape.

In the communication substrate 510, a flow path R1, a plurality of supply flow paths Ra, and a plurality of communication flow paths Na are provided for each of the first nozzle row Ln1 and the second nozzle row Ln2. The flow path R1 is a flow path which is provided in common to the plurality of nozzles N, communicates with the plurality of nozzles N, is located upstream of the nozzles N, and is configured as an elongated hole which extends in the direction along the Y axis in plan view as viewed in the direction along the Z axis. Each of the supply flow paths Ra and the communication flow paths Na is a flow path configured by a through hole formed for each nozzle N. Each supply flow path Ra communicates with the flow path R1.

The communication substrate 510 is manufactured, for example, through processing of a single-crystal silicon substrate by a semiconductor manufacturing technique, similarly to the nozzle plate 530 described above. However, other known methods and materials may be appropriately used to manufacture the communication substrate 510.

The pressure chamber substrate 520 is a plate-shaped member in which a plurality of pressure chambers C1 called cavities are provided for each of the first nozzle row Ln1 and the second nozzle row Ln2. The plurality of pressure chambers C1 are arranged in the direction along the Y axis. Each of the pressure chambers C1 is an elongated space formed for each nozzle N and extending in the direction along the X axis in plan view. As described above, the pressure chamber substrate 520 has the plurality of pressure chambers C1 arranged in the Y1 direction or the Y2 direction.

Similarly to the above-described nozzle plate 530, the pressure chamber substrate 520 is manufactured, for example, through processing of a single-crystal silicon substrate by a semiconductor manufacturing technique. However, other known methods and materials may be appropriately used to manufacture the pressure chamber substrate 520.

The pressure chambers C1 are located between the communication substrate 510 and the diaphragm 550. For each of the first nozzle row Ln1 and the second nozzle row Ln2, the plurality of pressure chambers C1 are arranged in the direction along the Y axis. Further, the pressure chambers C1 communicate with each of the communication flow paths Na and the supply flow paths Ra. Therefore, each pressure chamber C1 communicates with the nozzle N through the communication flow path Na and communicates with the flow path R1 through the supply flow path Ra.

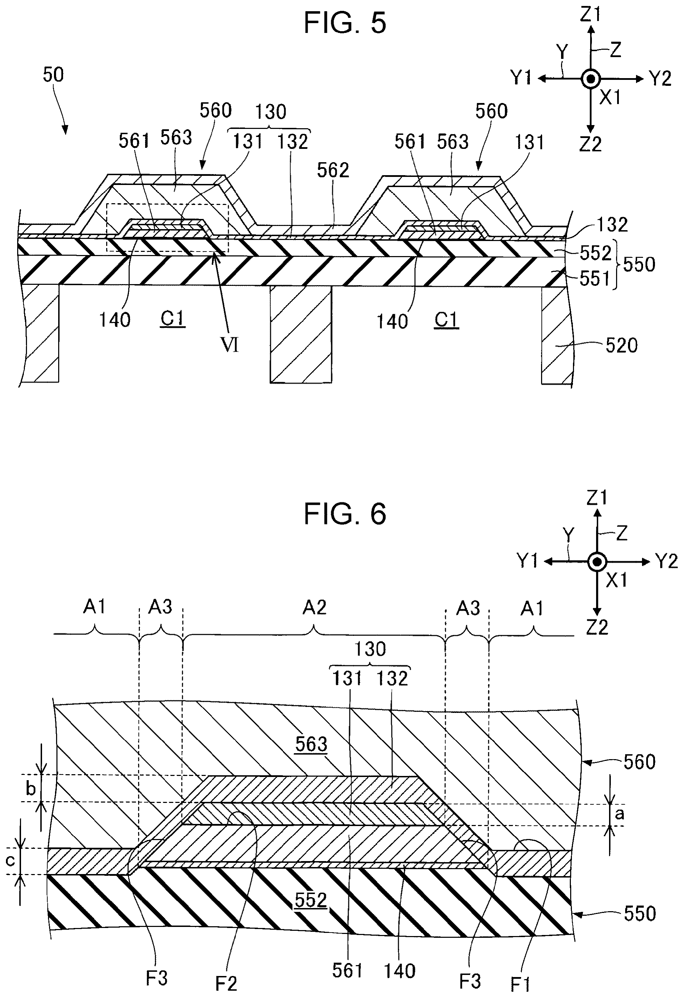

The diaphragm 550 is disposed on the pressure chamber substrate 520, more specifically, on a surface facing the Z1 direction of the pressure chamber substrate 520. The diaphragm 550 is a plate-shaped member that is elastically vibratable and is vibrated by the piezoelectric element 560. Details of the diaphragm 550 will be described later with reference to FIG. 5.

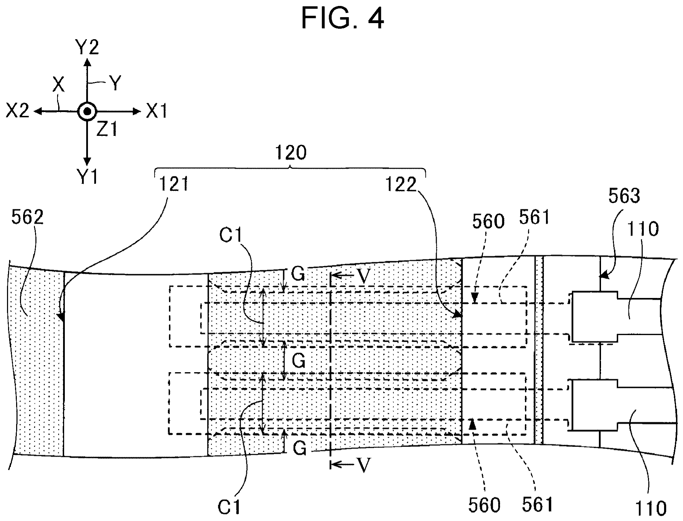

On the surface of the diaphragm 550 facing the Z1 direction, the plurality of piezoelectric elements 560 mutually corresponding to the nozzles N are arranged for each of the first nozzle row Ln1 and the second nozzle row Ln2. Each of the piezoelectric elements 560 is a passive element which is deformed by the supply of a potential corresponding to the drive signal Com and generates pressure fluctuation in the ink in the pressure chamber C1. Each piezoelectric element 560 has an elongated shape extending in the direction along the X axis in plan view. The plurality of piezoelectric elements 560 are arranged in the direction along the Y axis so as to correspond to the plurality of pressure chambers C1. The piezoelectric elements 560 overlap the pressure chambers C1 in plan view. The piezoelectric elements 560 described above apply pressure to the pressure chambers C1 communicating with the nozzles N that eject the ink. Details of the piezoelectric elements 560 will be described later with reference to FIGS. 4 to 6.

The protective substrate 570 is a plate-shaped member installed on the surface of the diaphragm 550 facing the Z1 direction, protects the plurality of piezoelectric elements 560, and reinforces the mechanical strength of the diaphragm 550. Here, the plurality of piezoelectric elements 560 are accommodated in a space S between the protective substrate 570 and the diaphragm 550. The protective substrate 570 is made of, for example, a resin material.

The case 580 is a case for storing the ink to be supplied to the plurality of pressure chambers C1. The case 580 is made of, for example, a resin material. The case 580 is provided with a flow path R2 for each of the first nozzle row Ln1 and the second nozzle row Ln2. The flow path R2 is a space coupled to the flow path R1 described above, and is formed of an elongated hole extending in the direction along the Y axis in plan view as viewed in the direction along the Z axis. The flow path R2 communicates with the nozzles N, and functions as a reservoir R that stores the ink to be supplied to the plurality of pressure chambers C1 together with the flow path R1. The case 580 is provided with an inlet HL for supplying the ink to each reservoir R. The ink in each reservoir R is supplied to the pressure chambers C1 through each supply flow path Ra. Note that aspects such as the position and the number of the inlet HL for each reservoir R are not limited to the examples of FIGS. 2 and 3, and are appropriately selected.

The vibration absorber 540, also referred to as a compliance substrate, is a flexible resin film constituting a wall surface of the reservoir R, and absorbs the pressure fluctuation of the ink in the reservoir R. The vibration absorber 540 may be a flexible thin plate made of metal. A surface of the vibration absorber 540 facing the Z1 direction is bonded to the communication substrate 510 with an adhesive or the like.

The wiring substrate 590 is a mounting component that is mounted on the surface of the diaphragm 550 facing the Z1 direction, and electrically couples the control module 20 and the liquid ejecting heads 50. The wiring substrate 590 is, for example, a flexible wiring substrate such as a chip on film (COF), a flexible printed circuit (FPC), or a flexible flat cable (FFC). The drive circuit 600 is mounted on the wiring substrate 590 of the present embodiment. The drive circuit 600 switches whether to supply a pulse included in the drive signal Com output from the control module 20 to each of the plurality of piezoelectric elements 560 included in the liquid ejecting head 50 under the control of the control module 20. As described above, the wiring substrate 590 supplies the drive signal Com for driving the piezoelectric element 560. The wiring substrate 590 may be a rigid substrate. In this case, the drive circuit 600 is mounted on the rigid substrate or a flexible substrate coupled to the rigid substrate.

### 1-3: Piezoelectric Element

FIG. 4 is a plan view of a portion of the liquid ejecting head 50 illustrated in FIG. 2. FIG. 5 is a sectional view taken along line V-V in FIG. 4. FIG. 6 is an enlarged view of portion VI in FIG. 5. In FIG. 4, for convenience of visibility, in a second electrode 562, which will be described later, a portion that is not covered by a second wiring 120, which will be described later, is indicated by dots.

Hereinafter, configurations of the diaphragm 550 and the piezoelectric element 560 will be described with reference to FIGS. 4 to 6.

The diaphragm 550 includes a first layer 551 and a second layer 552, and the first layer 551 and the second layer 552 are stacked in this order in the Z1 direction.

The first layer 551 is an elastic film made of, for example, silicon oxide (SiO₂), and is formed by thermally oxidizing one surface of a single-crystal silicon substrate. The second layer 552 is an insulating film made of, for example, zirconium oxide (ZrO₂), and is formed by forming a zirconium layer using a sputtering method and by thermally oxidizing the layer.

The diaphragm 550 is not limited to the above-described configuration in which the first layer 551 and the second layer 552 are stacked, and may be configured by, for example, a single layer or three or more layers. In addition, the material of each layer constituting the diaphragm 550 is not limited to the materials described above, and may be, for example, silicon, silicon nitride, or the like. For example, as a material constituting the second layer 552, TiO₂, Al₂O₃, SiO₂, SiN and the like can be used other than ZrO₂. Further, the ratio of thickness between the first layer 551 and the second layer 552 is not limited to the illustrated example, and may be appropriately selected.

The plurality of piezoelectric elements 560 are disposed on the surface of the diaphragm 550 facing the Z1 direction. As illustrated in FIG. 5, each piezoelectric element 560 includes a first electrode 561, a second electrode 562, a piezoelectric layer 563, and a seed layer 130. Those are denoted as the first electrode 561, the piezoelectric layer 563, the second electrode 562, and the seed layer 130, and are stacked in this order in the Z1 direction. As described above, the liquid ejecting head 50 includes the first electrode 561, the piezoelectric layer 563, the second electrode 562, and the seed layer 130.

In the piezoelectric element 560, when a voltage is applied between the first electrode 561 and the second electrode 562, the piezoelectric layer 563 is deformed due to an inverse piezoelectric effect. When the diaphragm 550 vibrates in conjunction with this deformation, the pressure in the pressure chamber C1 fluctuates, and thereby the ink is ejected from the nozzle N. Here, in the piezoelectric element 560, a portion in which the first electrode 561, the second electrode 562, and the piezoelectric layer 563 overlap each other when viewed in the direction along the Z axis is an active portion, and a portion other than the active portion is a non-active portion.

As illustrated in FIG. 4, a first wiring 110 is electrically coupled to the first electrode 561, and the drive signal Com is supplied via the first wiring 110. The first wiring 110 is a lead wire individually provided for each piezoelectric element 560, and is electrically coupled to the first electrode 561 of the corresponding piezoelectric element 560. On the other hand, the second wiring 120 is electrically coupled to the second electrode 562, and a constant potential is supplied via the second wiring 120. The second wiring 120 is a common wiring provided in common to the plurality of piezoelectric elements 560, and is electrically coupled to the second electrode 562.

In the example illustrated in FIG. 4, the first wiring 110 is coupled to the first electrode 561, and is drawn out from above the first electrode 561 toward the wiring substrate 590 for each piezoelectric element 560. On the other hand, the second wiring 120 is drawn out from above the second electrode 562 to above the diaphragm 550 in a direction toward the wiring substrate 590 at both end portions in the Y1 direction and the Y2 direction of the second electrode 562. Here, the second wiring 120 includes band-shaped conductive layers 121 and 122 extending in the Y1 direction. The conductive layer 121 and the conductive layer 122 are arranged at a predetermined interval in the X1 direction. The second wiring 120 also functions as a weight for suppressing a vibration of the diaphragm 550.

A constituent material of each of the first wiring 110 and the second wiring 120 is not particularly limited, and examples thereof include metals such as gold (Au), copper (Cu), titanium (Ti), tungsten (W), nickel (Ni), chromium (Cr), platinum (Pt), and aluminum (Al). In particular, gold (Au) is preferably used as a constituent material of the first wiring 110 and the second wiring 120. Here, for each of the first wiring 110 and the second wiring 120, a structure in which a layer made of gold is stacked as a surface layer on a layer made of, for example, nickel chromium or the like, is preferably used.

Each first electrode 561 is an individual electrode which is disposed on the diaphragm 550 and arranged apart from each other for each piezoelectric element 560. The drive signal Com is supplied to the first electrode 561. The second electrode 562 is a band-shaped common electrode which is disposed on the piezoelectric layer 563 and extends in the direction along the Y axis so as to be continuous over the plurality of piezoelectric elements 560. For example, the constant potential is supplied to the second electrode 562.

Examples of a material constituting each of the first electrode 561 and the second electrode 562 include metal materials such as platinum (Pt), aluminum (Al), iridium (Ir), nickel (Ni), gold (Au), and copper (Cu), and among the materials, one type can be used alone, or two or more types can be used in combination in an aspect of alloy or stacking or the like.

In a case where the first electrode 561 contains Ir, as will be described later, it is possible to suppress diffusion of a component included in the piezoelectric layer 563. As a result, a change in the composition of the piezoelectric layer 563 can be suppressed.

In the examples illustrated in FIGS. 5 and 6, an adhesion layer 140 is disposed between the diaphragm 550 and the first electrodes 561. The adhesion layer 140 is a layer for increasing adhesion between the first electrode 561 and the diaphragm 550, and is formed of a metal such as titanium, for example. At least a portion of the adhesion layer 140 may be regarded as a portion of the first electrode 561 or the diaphragm 550. In addition, a layer formed of titanium may be interposed between the first electrode 561 and the diaphragm 550 for some reason.

The piezoelectric layer 563 is disposed on the first electrode 561 and is formed of a piezoelectric material. As the piezoelectric material, a composite oxide having a perovskite structure represented by a general compositional formula ABO₃ is preferably used. Examples of the composite oxide include lead zirconate titanate (Pb(Zr,Ti)O₃) and lead magnesium niobate-lead titanate solid solution (Pb(Mg,Nb)O₃-PbTiO₃). The composite oxide is not limited to the above-mentioned lead-containing compounds, and may be lead-free compounds, for example, potassium sodium niobate ((K,Na)NbO₃, abbreviated as "KNN"), bismuth ferrite ((BiFeO₃), abbreviated as "BFO"), potassium sodium lithium niobate ((K,Na,Li)(NbO₃)), potassium sodium lithium niobate tantalate ((K,Na,Li)(Nb,Ta)O₃), bismuth manganate (BiMnO₃, abbreviated as "BM"), and the like. When the piezoelectric layer 563 contains K, Na, and Nb as described above, the piezoelectric layer 563 can be made of a material that does not contain lead.

In the example illustrated in FIG. 4, the piezoelectric layer 563 has a band shape extending in the direction along the Y axis so as to be continuous over the plurality of piezoelectric elements 560. Here, the piezoelectric layer 563 includes a notch G passing through the piezoelectric layer 563 and extending in the direction along the X axis in a region corresponding to a gap between each of the pressure chambers C1 adjacent to each other in plan view. The piezoelectric layer 563 may be individually provided for each piezoelectric element 560. Further, the notch G may be a groove with a bottom.

As illustrated in FIG. 6, the piezoelectric layer 563 has a first region A1, a second region A2, and a third region A3. The first region A1 is a region that is included in the piezoelectric layer 563 and does not overlap with the first electrode 561 in the Y1 direction or the Y2 direction. In other words, the first region A1 is a region of which the range in the direction along the Y axis is different from the range of the first electrode 561 in the piezoelectric layer 563. On the other hand, the second region A2 is a region that is included in the piezoelectric layer 563 and overlaps with the first electrodes 561 in the Y1 direction or the Y2 direction. In other words, the second region A2 is a region of which the range in the direction along the Y axis is the same range as the first electrodes 561 in the piezoelectric layer 563. In addition, the third region A3 is a region that is included in the piezoelectric layer 563 and located between the first region A1 and the second region A2 in the Y1 direction or the Y2 direction.

In the example illustrated in FIG. 6, the first region A1 is a region to be stacked on a region F1, which is on the upper surface of the diaphragm 550 and flat in the Y1 direction or the Y2 direction when viewed in a cross-section orthogonal to the X axis. It can also be said that the region F1 is a region of the upper surface of the diaphragm 550, and the region is flat along a virtual plane orthogonal to the Z axis. On the other hand, the second region A2 is a region to be stacked on a region F2, which is on the upper surface of the first electrode 561 and flat in the Y1 direction or the Y2 direction when viewed in a cross-section orthogonal to the X axis. It can also be said that the region F2 is a region of the upper surface of the first electrode 561, and the region is flat along a virtual plane orthogonal to the Z axis. The third region A3 is a region to be stacked on a region F3, which is on the upper surface of the first electrode 561 and inclined with respect to the Y1 direction or the Y2 direction when viewed in the cross-section orthogonal to the X axis. It can also be said that the region F3 is a region of the upper surface of the first electrode 561, and the region is flat and inclined around the X axis with respect to a virtual plane orthogonal to the Z axis.

The inclination angle of the region F3 with respect to the virtual plane orthogonal to the Z axis may be larger than 0° and smaller than 90°, and is not particularly limited and is appropriately selected. In addition, the inclination of the region F3 with respect to the virtual plane orthogonal to the Z axis is formed by, for example, adjustment of an etching rate when the first electrode 561 is patterned by etching or the like, or use of a grayscale mask, or the like.

The seed layer 130 is located between the piezoelectric layer 563 and the diaphragm 550, and is a layer for controlling the orientation of the piezoelectric layer 563. The seed layer 130 is in contact with each of the first electrode 561, the diaphragm 550, and the piezoelectric layer 563, and has a crystal structure serving as a seed crystal of the piezoelectric layer 563. Thus, the orientation of the piezoelectric layer 563 can be improved. As a result, the displacement capability of the piezoelectric element 560 can be increased. Therefore, the ejection performance of the liquid ejecting head 50 can be improved.

A material constituting the seed layer 130 may be any material as long as the material has a function of controlling the orientation of the piezoelectric layer 563, but the material preferably contains titanium (Ti), and more preferably contains bismuth (Bi), iron (Fe), titanium (Ti), and lead (Pb). A material containing bismuth (Bi), iron (Fe), titanium (Ti), and lead (Pb) can control the orientation of the piezoelectric layer 563 as a composite oxide having a perovskite structure containing Bi and Pb in an A-site and Fe and Ti in a B-site.

The seed layer 130 includes a first seed layer 131 and a second seed layer 132. The first seed layer 131 is not disposed in the first region A1, but is disposed in the second region A2. The second seed layer 132 is provided on the first seed layer 131 and is disposed over both the first region A1 and the second region A2.

Each of the first seed layer 131 and the second seed layer 132 is formed of a material capable of controlling the orientation of the piezoelectric layer 563 as described above. Here, since the second seed layer 132 is disposed over both the first region A1 and the second region A2, it is possible to control the orientation of the piezoelectric layer 563 in both the active portion and the non-active portion. Therefore, it is possible to reduce the occurrence of damage such as cracks due to a difference in the orientation of the piezoelectric layer 563 between the active portion and the non-active portion.

Moreover, since the second seed layer 132 is provided on the first seed layer 131, the second seed layer 132 is formed after the formation of the first seed layer 131, as will be described in detail later. Further, a heat treatment of the first seed layer 131 can be performed before a patterning of the first electrode 561 and the first seed layer 131. Among the materials of a layer such as the adhesion layer 140 immediately below the first electrode 561, a material (in particular, Ti) capable of diffusing cannot diffuse in the lateral direction but diffuses in the thickness direction during the heat treatment. Therefore, during the heat treatment, the material of a layer such as the adhesion layer 140 does not precipitate intensively. In addition, the heat treatment of the second seed layer 132 is performed after the patterning of the first seed layer 131, and therefore, among the materials of a layer such as the adhesion layer 140, a material capable of diffusing has completely diffused before the heat treatment. For this reason, the material of a layer such as the adhesion layer 140 does not precipitate intensively at an end portion of the first electrode 561 during the heat treatment. As described above, it is also possible to reduce the occurrence of damage such as cracks due to the occurrence of local segregation of a material such as Ti of a layer such as the adhesion layer 140.

Here, in a case where the first electrode 561 contains Ir, Ir contained in the first electrode 561 is easily diffused by the heat treatment. The effect of Ir to suppress the diffusion of Ti is particularly remarkable as compared with combinations of other elements. Therefore, in a case where Ti is segregated, when Ir is contained in the first electrode 561, the effect of reducing the occurrence of local segregation of the material of a layer such as the adhesion layer 140 is remarkably demonstrated by using the first seed layer 131 and the second seed layer 132.

In addition, in a case where the piezoelectric layer 563 contains K, Na, and Nb, since the piezoelectric layer 563 does not contain Ti, when the first electrode 561 contains Ti, the affinity between the first electrode 561 and the piezoelectric layer 563 decreases. Therefore, when Ti diffuses from a layer such as the adhesion layer 140, Ti is precipitated at an end portion of the first electrode 561 without entering the piezoelectric layer 563. Therefore, in this case, by using the first seed layer 131 and the second seed layer 132, the effect of reducing the occurrence of local segregation of the material of a layer such as the adhesion layer 140 is remarkably demonstrated.

The first seed layer 131 is not disposed in the third region A3, whereas the second seed layer 132 is also disposed in the third region A3. Thus, the orientation of the third region A3 can be improved. Here, when the first electrode 561 and the first seed layer 131 are formed by a collective patterning, the first seed layer 131 cannot be formed in the region F3 of the first electrode 561. If the seed layer 130 is not present in the region F3, the third region A3 between the first region A1 and the second region A2 becomes non-oriented, and therefore, a large difference in the orientation between these regions occurs, and as a result, there is a concern that a crack may occur. On the other hand, by providing the second seed layer 132 on the region F3, the orientation of the third region A3 can be improved. As a result, generation of cracks can be reduced by reducing the difference in the orientation between these regions.

When the thicknesses of the first seed layer 131 in the second region A2, the second seed layer 132 in the second region A2, and the second seed layer 132 in the first region A1 are represented by a, b, and c, respectively, it is preferable to satisfy a + b > c. In other words, the thickness (a + b) of the seed layer 130 in the second region A2 is preferably larger than the thickness c of the seed layer 130 in the first region A1. Thus, the crystallinity of both the first region A1 and the second region A2 of the piezoelectric layer 563 can be preferably increased. As a result, generation of cracks in the piezoelectric layer 563 is preferably reduced.

Here, in general, as the thickness of the seed layer 130 increases, the crystallinity of the piezoelectric layer 563 improves. However, for example, in a case where KNN is used as a material of the piezoelectric layer 563 and ZrO_{X} is used as a material of the second layer 552 of the diaphragm 550, regarding the seed layer 130 on the second layer 552, the crystallinity of the piezoelectric layer 563 may decrease when the seed layer 130 is excessively thick, contrary to general cases. Therefore, if the seed layer 130 in the non-active portion is formed to have a thickness equal to or larger than the thickness of the seed layer 130 in the active portion, the crystallinity of the piezoelectric layer 563 decreases extremely since the piezoelectric layer 563 is directly stacked on the diaphragm 550 in the non-active portion. As a result, cracks may be generated as in a case where the piezoelectric layer 563 in the non-active portion becomes non-oriented.

Therefore, it is preferable that the thicknesses a, b, and c satisfy the above-described relationship. Accordingly, since the decrease of the crystallinity of the piezoelectric layer 563 in the non-active portion as described above is reduced, it is possible to preferably increase the crystallinity of both the first region A1 and the second region A2 of the piezoelectric layer 563.

When the thicknesses of the second seed layer 132 in the second region A2 and the second seed layer 132 in the first region A1 are represented by b and c, respectively, it is preferable to satisfy b < c. Thus, the seed layer 130 in the second region A2 is prevented from being thicker than necessary. As a result, the orientation of the piezoelectric layer 563 is preferably controlled in both the active portion and the non-active portion. Here, since the first seed layer 131 is present in the active portion, the orientation of the piezoelectric layer 563 can be controlled by the first seed layer 131. On the other hand, since the first seed layer 131 is not present in the non-active portion, it is necessary to perform the orientation control of the piezoelectric layer 563 by the second seed layer 132. Therefore, by setting the thickness c of the second seed layer 132 in the first region A1 to be thicker than the thickness b of the second seed layer 132 in the second region A2, in other words, by satisfying b < c, the orientation control of the piezoelectric layers 563 in both the active portion and the non-active portion is preferably performed.

On the other hand, if the thickness c of the second seed layer 132 in the first region A1 is smaller than the thickness b of the second seed layer 132 in the second region A2, the seed layer 130 in the active portion is too thick to control the orientation of the piezoelectric layer 563 in both the active portion and the non-active portion, and thus there is a problem that, due to the increase of electrical resistance of the seed layer 130 in the active portion, conductivity between the first electrode 561 and the piezoelectric layer 563 deteriorates, thereby decreasing ejection characteristics.

When the thicknesses of the first seed layer 131 in the second region A2, the second seed layer 132 in the second region A2, and the second seed layer 132 in the first region A1 are represented by a, b, and c, respectively, it is preferable to satisfy b < a < c and a + b > c. Thus, b < c can be satisfied and a + b > c can be satisfied so that the difference between the thickness (a + b) and the thickness c does not become too large.

Each of the first seed layer 131 and the second seed layer 132 is at least partially in contact with the first electrode 561. The first seed layer 131 and the second seed layer 132 described above can be obtained by forming the second seed layer 132 after forming the first seed layer 131.

The first seed layer 131 and the second seed layer 132 are preferably made of the same material as each other. Accordingly, the affinity between the first seed layer 131 and the second seed layer 132 is increased, whereby a mutual adhesion between the first seed layer 131 and the second seed layer 132 can be increased. As a result, detachment between the first seed layer 131 and the second seed layer 132 can be reduced. On the other hand, when the first seed layer 131 and the second seed layer 132 are formed of different materials from each other, the affinity between the first seed layer 131 and the second seed layer 132 may be deteriorated, and the mutual adhesion between the first seed layer 131 and the second seed layer 132 may be deteriorated, thereby causing detachment between the first seed layer 131 and the second seed layer 132.

Each of the first seed layer 131 and the second seed layer 132 preferably contains Ti. Thus, it is possible to achieve the first seed layer 131 and the second seed layer 132 capable of preferably controlling the orientation of the piezoelectric layer 563.

Each of the first seed layer 131 and the second seed layer 132 preferably contains Bi, Fe, Ti, and Pb. Thus, the seed layer 130 can be formed of a composite oxide having a perovskite structure, therefore the orientation of the piezoelectric layer 563 can be preferably enhanced.

When both the first seed layer 131 and the second seed layer 132 are provided, since the second seed layer 132 is present in both the first region A1 and the second region A2, each of the first region A1 and the second region A2 is preferentially oriented to a (100) plane, and orientation states of the first region A1 and the second region A2 are very similar to each other. As described above, when both the first seed layer 131 and the second seed layer 132 are provided, the first region A1 and the second region A2 are both preferentially oriented to the same crystal plane orientation.

On the other hand, when only the first seed layer 131 is provided, the first seed layer 131 is present only in the second region A2. Therefore, the second region A2 is preferentially oriented to the (100) plane, whereas the first region A1 is not preferentially oriented to the (100) plane. Further, in this case, the difference in the orientation states between the first region A1 and the second region A2 is large.

### 1-4: Method of Manufacturing Liquid Ejecting Head

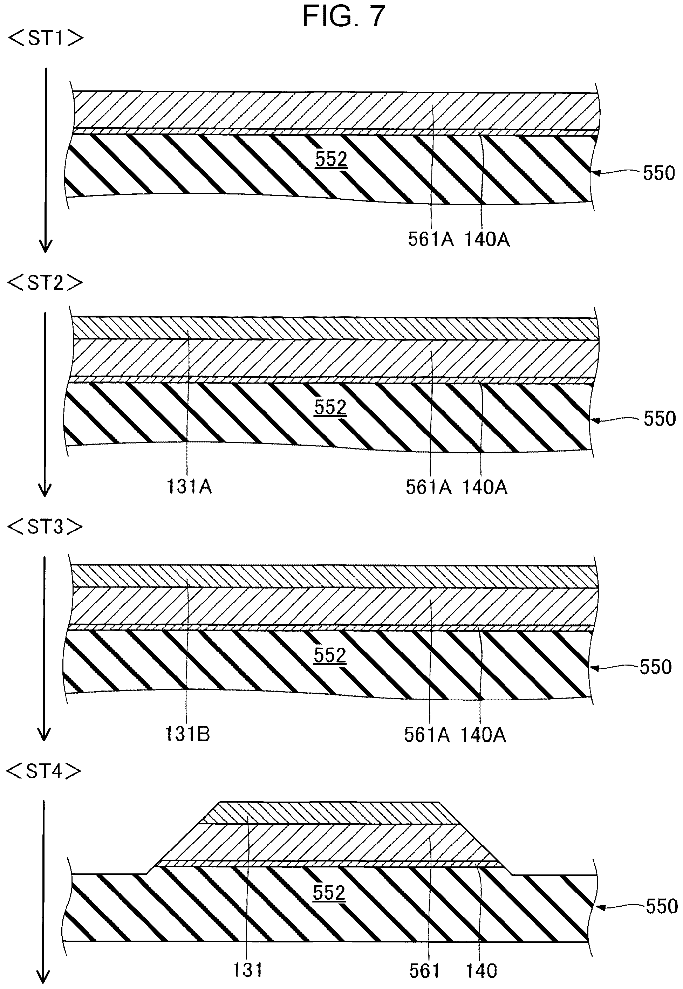

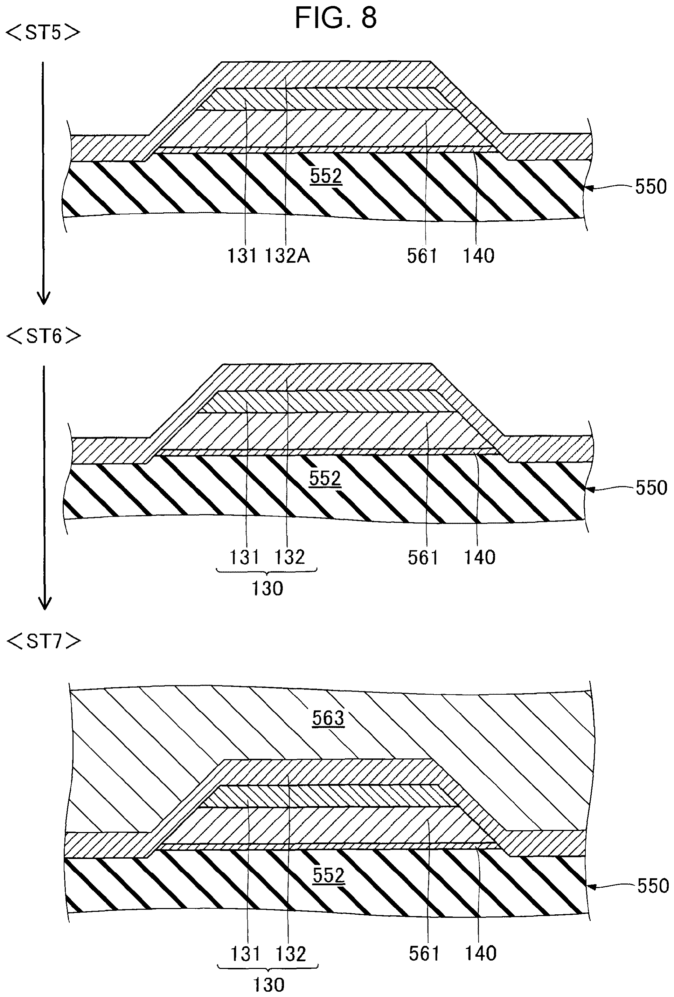

FIGS. 7 and 8 are explanatory views of a method of manufacturing a liquid ejecting head 50 according to the embodiments. In the method of manufacturing the liquid ejecting head 50, as illustrated in FIGS. 7 and 8, steps ST1 to ST7 are performed in this order. Hereinafter, each step will be described in order.

In the step ST1, a layer 561A to be formed of a material of the first electrode 561 is applied onto the diaphragm 550. To be more specific, in the step ST1, for example, after the diaphragm 550 is formed, an adhesion layer 140A is uniformly formed by forming a film of a metal such as titanium on the second layer 552 using the sputtering method, and then the layer 561A is to be uniformly formed by forming a film of a metal such as platinum on the adhesion layer 140A using the sputtering method.

In the step ST2, after the step ST1, a layer 131A to be formed of a material of the first seed layer 131 is applied onto the layer 561A to be formed of the material of the first electrodes 561. To be more specific, in the step ST2, for example, a solution such as a MOD solution containing a precursor material of the first seed layer 131 is applied onto the layer 561A using a spin coating method or the like, thereby forming the layer 131A which is a precursor layer of the first seed layer 131.

In the step ST3, after the step ST2, the layer 131A formed of the material of the first seed layer 131 is heat-treated. To be more specific, in the step ST3, for example, after the layer 131A which is the precursor layer of the first seed layer 131 is dried and degreased at about 350°C by an oven or the like, a heat treatment is performed at about 750°C for about five minutes by rapid thermal annealing (RTA) or the like. Accordingly, a layer 131B, in which the precursor constituting the layer 131A has been crystallized by firing, is formed. Note that the conditions of the heat treatment are not limited to the above-described example and can be appropriately changed.

In the step ST4, after the step ST3, the layer 561A formed of the material of the first electrodes 561 and the layer 131B formed of the material of the first seed layer 131 are patterned. To be more specific, in the step ST4, for example, the layer 561A and the layer 131B are collectively patterned by a known processing technique using photolithography, etching, and the like. Thus, a patterned first electrode 561 is formed, and a patterned first seed layer 131 is formed. At this time, the adhesion layer 140 is formed by patterning the adhesion layer 140A.

In the step ST5, after the step ST4, a layer 132A to be formed of a material of the second seed layer 132 is applied onto the diaphragm 550 and onto the first seed layer 131 (a layer formed of the material of the first seed layer 131). To be more specific, in the step ST5, for example, a solution such as a MOD solution containing a precursor material of the second seed layer 132 is applied over onto the diaphragm 550 and onto the first seed layer 131 using the spin coating method or the like, thereby forming the layer 132A which is a precursor layer of the second seed layer 132.

In the step ST6, after the step ST5, the layer 132A formed of the material of the second seed layer 132 is heat-treated. To be more specific, in the step ST6, for example, after the layer 132A which is the precursor layer of the second seed layer 132 is dried and degreased at about 350°C by an oven or the like, a heat treatment is performed at about 750°C for about five minutes by RTA or the like. Accordingly, the second seed layer 132, in which the precursor constituting the layer 132A has been crystallized by firing, is formed. Note that the conditions of the heat treatment are not limited to the above-described example and can be appropriately changed. In addition, conditions such as the temperature and the duration of the heat treatment in the step ST6 may be the same as or different from the conditions of the heat treatment in the step ST3.

In the step ST7, after the step ST6, a piezoelectric body is applied onto the second seed layer 132 (a layer formed of the material of the second seed layer 132). To be more specific, in the step ST7, for example, a solution such as a MOD solution containing a precursor material of the piezoelectric body is applied onto the second seed layer 132 using a spin coating method or the like, thereby forming the precursor layer of the piezoelectric layer 563, and then, after the precursor layer is dried and degreased at about 350°C by an oven or the like, a heat treatment is performed at about 750°C for about five minutes by RTA or the like. Thus, the piezoelectric layer 563 is formed. Note that the application of the piezoelectric body and the heat treatment may be performed in a plurality of separate times. In addition, the conditions of the heat treatment are not limited to the above-described example and can be appropriately changed.

After the above-described step ST7, although not illustrated, the piezoelectric layer 563 is patterned by a known processing technique using photolithography, etching, and the like. At this time, a portion of the second seed layer 132 is also removed by the patterning so that a shape of the second seed layer 132 in plan view coincides with a shape of the piezoelectric layer 563 in plan view. Thus, the piezoelectric element 560 is obtained. Thereafter, the liquid ejecting head 50 is obtained through a known appropriate process. The patterning of the piezoelectric layer 563 is performed, for example, after the pressure chamber C1 is formed in the pressure chamber substrate 520.

In the above-described method of manufacturing a liquid ejecting head 50, the heat treatment of the step ST3 is performed before the patterning of the step ST4. Among the materials of a layer such as the adhesion layer 140A immediately below the layer 561A, a material such as Ti capable of diffusing cannot diffuse in the lateral direction but diffuses in the thickness direction during the heat treatment. Therefore, the material of a layer such as the adhesion layer 140A does not precipitate intensively during the heat treatment. In addition, the heat treatment of the second seed layer 132 is performed in the step ST6 after the patterning in the step ST4, and therefore, among the materials of a layer such as the adhesion layer 140, a material capable of diffusing has completely diffused in the step ST3 before the heat treatment. For this reason, during the heat treatment, the material of a layer such as the adhesion layer 140 does not precipitate intensively at an end portion of the first electrode 561. As described above, it is also possible to reduce the generation of cracks due to the occurrence of local segregation of a material of the layer such as the adhesion layer 140.

Hereinafter, effects of the above manufacturing method will be described in comparison with Comparative Examples 1 and 2.

### Comparative Example 1

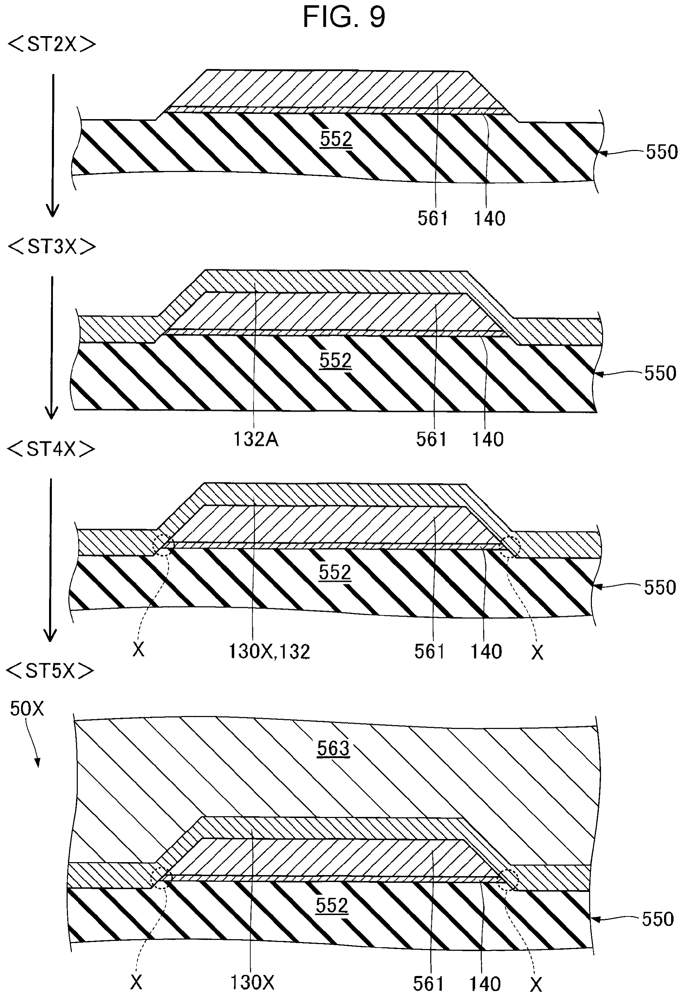

FIG. 9 is an explanatory view of a method of manufacturing a liquid ejecting head 50X according to Comparative Example 1. The liquid ejecting head 50X is configured similarly to the liquid ejecting head 50 except that the liquid ejecting head 50X includes a seed layer 130X instead of the seed layer 130. The seed layer 130X is configured similarly to the seed layer 130 except that the first seed layer 131 is omitted. That is, the seed layer 130X is formed of only the second seed layer 132.

In the method of manufacturing a liquid ejecting head 50X, as illustrated in FIG. 9, steps ST2X to ST5X are performed in this order. Hereinafter, each step will be described in order. In the following, the description of the same matters as those in the method of manufacturing a liquid ejecting head 50 will be appropriately used or omitted.

In the step ST2X, after the step ST1 described above, a layer 561A formed of the material of the first electrodes 561 is patterned. As a result, a first electrode 561 formed of the patterned first electrode 561 and the adhesion layer 140 is formed.

In the step ST3X, after the step ST2X, a layer 132A to be formed of the material of the second seed layer 132 is applied onto the diaphragm 550 and the first electrode 561.

In the step ST4X, after the step ST3X, the layer 132A formed of the material of the second seed layer 132 is heat-treated. Thus, a seed layer 130X, in which the layer 132A that is a precursor has been crystallized by firing, is formed.

In the step ST5X, after step ST4X, the piezoelectric body is applied onto the seed layer 130X. Thus, the piezoelectric layer 563 is formed.

In the above-described method of manufacturing a liquid ejecting head 50X, among the materials of a layer such as the adhesion layer 140, a material such as Ti capable of diffusing, diffuses into other layers during the heat treatment in the step ST4X. However, the first electrode 561 (in particular, Ir or the like included in the first electrode 561) has a property that makes it difficult to diffuse Ti or the like. Since the first electrode 561 is disposed on the upper side of the adhesion layer 140 at the time of the heat treatment in the step ST4X, a material such as Ti does not easily advance to the upper side of the adhesion layer 140. However, since the patterning in the step ST2X is performed before the heat treatment in the step ST4X, there is nothing to suppress the diffusion of Ti on end portions of the first electrode 561 (in particular, tapered portions of regions X) during the heat treatment in the step ST4X. Therefore, Ti or the like is segregated in the vicinity of the end portions of the first electrode 561 during the heat treatment in the step ST4X. When such local segregation of Ti or the like occurs, the material becomes an oxide such as TiO_{X}, and a detached portion or the like occurs in the piezoelectric body formed at the end portions of the first electrode 561, and such a detached portion may cause a crack.

### Comparative Example 2

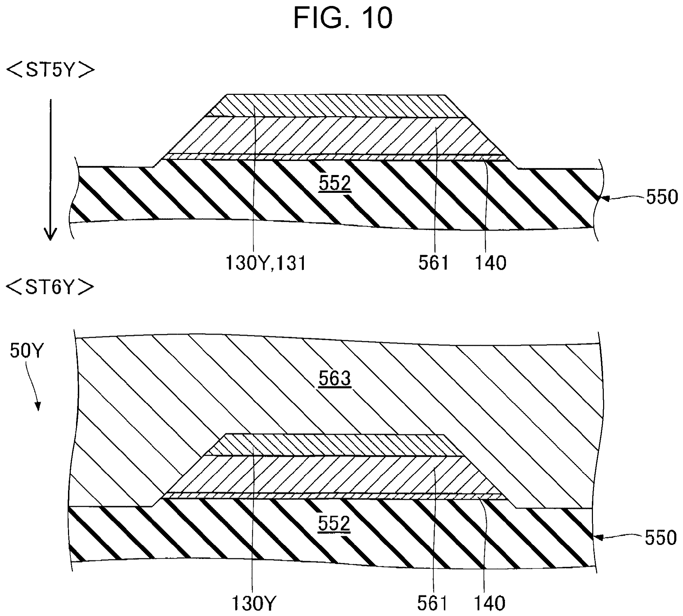

FIG. 10 is an explanatory view of a method of manufacturing a liquid ejecting head 50Y according to Comparative Example 2. The liquid ejecting head 50Y is configured similarly to the liquid ejecting head 50 except that the liquid ejecting head 50Y includes a seed layer 130Y instead of the seed layer 130. The seed layer 130Y is configured similarly to the seed layer 130 except that the second seed layer 132 is omitted. That is, the seed layer 130Y is formed of only the first seed layer 131.

In the method of manufacturing a liquid ejecting head 50Y, as illustrated in FIG. 10, steps ST5Y and ST6Y are performed in this order. Hereinafter, each step will be described in order. In the following, the description of the same matters as those in the method of manufacturing a liquid ejecting head 50 will be appropriately used or omitted.

In the step ST5Y, by performing the steps ST1 to ST4 described above, a patterned first electrode 561 is formed and a seed layer 130Y which is a patterned first seed layer 131 is formed.

In the step ST6Y, after the step ST5Y, the piezoelectric body is applied over onto the diaphragm 550 and onto the seed layer 130Y. Thus, the piezoelectric layer 563 is formed.

In the above-described method of manufacturing a liquid ejecting head 50Y, the first electrode 561 and the seed layer 130Y are formed by performing the steps ST1 to ST4. Therefore, similarly to the method of manufacturing a liquid ejecting head 50, segregation of a material such as Ti of a layer such as the adhesion layer 140A is eliminated. The mechanism is considered to be as described in the method of manufacturing a liquid ejecting head 50. That is, since the patterning of the layer 561A is not performed at the time of the heat treatment in the step ST3, the layer 561A is formed over the entire region on the upper side of the material such as Ti that is about to diffuse, and there is no escape path for the material as the tapered portion of the region F3 in Comparative Example 1. Therefore, even when the layer 131A is heat-treated in the step ST3, the material such as Ti is not segregated in a specific region as in Comparative Example 1, and most of the material escapes to the diaphragm 550 (more specifically, the second layer 552 formed of a ZrO_{X} or the like). Accordingly, segregation of Ti or the like at an end portion of the first electrode 561 can be suppressed.

However, in Comparative Example 2, the seed layer 130Y is not provided in the non-active portion. Therefore, the orientation of the piezoelectric layer 563 greatly differs between the active portion and the non-active portion, and a crack is generated at the boundary therebetween.

In contrast, in the method of manufacturing a liquid ejecting head 50 illustrated in FIGS. 7 and 8, since the second seed layer 132 is disposed over both the active portion and the non-active portion, it is possible to control the orientation of the piezoelectric layer 563 in both the active portion and the non-active portion. Therefore, it is possible to reduce the generation of cracks due to the difference in the orientation of the piezoelectric layer 563 between the active portion and the non-active portion.

In addition, in Comparative Example 1, it can be considered to perform a heat treatment only to completely diffuse a material such as Ti of a layer such as the adhesion layer 140 between the step ST1 and the step ST2X. However, in that case, since the heat treatment is performed in a state where the layer 561A is exposed, the surface of the layer 561A is roughened, and, as a result, there is a problem that deterioration in the orientation of the piezoelectric layer 563 is caused by deterioration in the characteristics of the seed layer 130X. On the other hand, since the heat treatment is performed in the step ST3 in a state where the surface of the layer 561A is protected by the layer 131A, such a problem does not occur, and a material such as Ti of a layer such as the adhesion layer 140 completely diffuses without being segregated.

### 2: Modifications

Each of the above-described embodiments can be variously modified. Specific modifications that can be applied to each of the above-described embodiments will be described below. Two or more aspects appropriately selected from the following examples can be combined as appropriate to the extent that these aspects do not contradict each other.

### 2-1: Modification Example 1

In the above-described embodiments, an aspect in which the second electrode 562 is a common electrode is exemplified, but the present disclosure is not limited to this aspect, and the second electrode 562 may be an individual electrode for each piezoelectric element 560. In this case, the first electrode 561 may be a common electrode common to the plurality of piezoelectric elements 560. However, even when the first electrode 561 is used as a common electrode and the second electrode 562 is used as an individual electrode, the piezoelectric layer 563 includes a region that does not overlap the first electrode 561.

### 2-2: Modification Example 2

In each of the above-described embodiments, a serial-type liquid ejecting apparatus 100 that reciprocates the transport body 41 mounted with the liquid ejecting head 50 has been exemplified, but the present disclosure is also applied to a line-type liquid ejecting apparatus in which the plurality of nozzles N are distributed over the entire width of the recording medium M.

### 2-3: Modification Example 3

The liquid ejecting apparatus 100 described in the above-described embodiment may be used in not only an apparatus dedicated to printing but also various apparatuses such as a facsimile machine and a copy machine, and the application of the present disclosure is not particularly limited. However, the application of the liquid ejecting apparatus is not limited to printing. For example, a liquid ejecting apparatus that ejects a solution of a coloring material is used as a manufacturing device that forms a color filter of a display device such as a liquid crystal display panel. In addition, a liquid ejecting apparatus that ejects a solution of a conductive material is used as a manufacturing apparatus that forms a wiring or an electrode on a wiring substrate. In addition, a liquid ejecting apparatus that ejects a solution of an organic substance related to a living body is used, for example, as a manufacturing apparatus that manufactures a biochip.

## Claims

1. A liquid ejecting head comprising:
a pressure chamber substrate having a plurality of pressure chambers arranged in a first direction;
a diaphragm disposed on the pressure chamber substrate;
a first electrode disposed on the diaphragm;
a piezoelectric layer disposed on the first electrode;
a second electrode disposed on the piezoelectric layer; and
a seed layer located between the piezoelectric layer and the diaphragm, for controlling orientation of the piezoelectric layer, wherein
the piezoelectric layer includes a first region not overlapping the first electrode in the first direction and includes a second region overlapping the first electrode in the first direction, and
the seed layer includes
a first seed layer disposed not in the first region but in the second region, and
a second seed layer provided on the first seed layer and disposed over both the first region and the second region.

2. The liquid ejecting head according to claim 1, wherein
when
a thickness of the first seed layer in the second region is represented by a,
a thickness of the second seed layer in the second region is represented by b, and
a thickness of the second seed layer in the first region is represented by c,
a + b > c is satisfied.

3. The liquid ejecting head according to claim 1, wherein
when
a thickness of the second seed layer in the second region is represented by b, and
a thickness of the second seed layer in the first region is represented by c,
b < c is satisfied.

4. The liquid ejecting head according to claim 1, wherein
when
a thickness of the first seed layer in the second region is represented by a,
a thickness of the second seed layer in the second region is represented by b, and
a thickness of the second seed layer in the first region is represented by c,
b < a < c and a + b > c is satisfied.

5. The liquid ejecting head according to claim 1, wherein
each of the first seed layer and the second seed layer is at least partially in contact with the first electrode.

6. The liquid ejecting head according to claim 1, wherein
the first seed layer and the second seed layer are made of a same material as each other.

7. The liquid ejecting head according to claim 1, wherein
each of the first seed layer and the second seed layer contains Ti.

8. The liquid ejecting head according to claim 1, wherein
each of the first seed layer and the second seed layer contains Bi, Fe, Ti, and Pb.

9. The liquid ejecting head according to claim 1, wherein
the first electrode contains Ir.

10. The liquid ejecting head according to claim 1, wherein
the piezoelectric layer contains K, Na, and Nb.

11. The liquid ejecting head according to claim 1, wherein
the first region is a region to be stacked on a flat region in the first direction of an upper surface of the diaphragm, and
the second region is a region to be stacked on a flat region in the first direction of the upper surface of the first electrode.

12. The liquid ejecting head according to claim 11, wherein
the piezoelectric layer further includes a third region located between the first region and the second region in the first direction, and
the third region is a region to be stacked on an inclined region of the upper surface of the first electrode, the inclined region being inclined with respect to the first direction.

13. The liquid ejecting head according to claim 12, wherein
the first seed layer is not disposed in the third region, and
the second seed layer is also disposed in the third region.

14. A liquid ejecting apparatus comprising:
the liquid ejecting head according to claim 1; and
a control section that controls an ejecting operation from the liquid ejecting head.

15. A method of manufacturing a liquid ejecting head that includes a pressure chamber substrate having a plurality of pressure chambers arranged in a first direction and a diaphragm disposed on the pressure chamber substrate, the method comprising, in order:
applying a layer to be formed of a material of a first electrode onto the diaphragm;
applying a layer to be formed of a material of a first seed layer onto the layer to be formed of the material of the first electrode;
subjecting the layer formed of the material of the first seed layer to heat treatment;
patterning the layer formed of the material of the first electrode and the layer formed of the material of the first seed layer;
applying a layer to be formed of a material of a second seed layer onto the diaphragm and onto the layer formed of the material of the first seed layer;
subjecting the layer formed of the material of the second seed layer to heat treatment; and
applying a piezoelectric body on the layer formed of the material of the second seed layer.
